# EUROPÄISCHE PATENTSCHRIFT

(11) **EP 0 708 986 B1**
(45) Veröffentlichungstag und Bekanntmachung des Hinweises auf die Patenterteilung: **01.04.1998**
(21) Anmeldenummer: 94920390.5
(22) Anmeldetag: 08.07.1994
(51) Int. Cl.: H01L 37/02, G01J 5/34

(54) **PYRODETEKTORELEMENT MIT ORIENTIERT AUFGEWACHSENER PYROELEKTRISCHER SCHICHT UND VERFAHREN ZU SEINER HERSTELLUNG**
PYRODETECTOR ELEMENT WITH AN EPITAXIALLY GROWN PYROELECTRIC LAYER AND PROCESS FOR PRODUCING THE SAME
PYRODETECTEUR COMPORTANT UNE COUCHE PYROELECTRIQUE FORMEE PAR CROISSANCE EPITAXIALE ET SON PROCEDE DE REALISATION

(30) Priorität: 15.07.1993 DE 4323821
(43) Veröffentlichungstag der Anmeldung: 01.05.1996
(73) Patentinhaber: SIEMENS AKTIENGESELLSCHAFT, 80333 München (DE)
(72) Erfinder: WERSING, Wolfram, D-85551 Kirchheim (DE); BRUCHHAUS, Rainer, D-80997 München (DE)
(86) Internationale Anmeldenummer: DE9400785
(87) Internationale Veröffentlichungsnummer: WO9502904

(56) Entgegenhaltungen:
- EP-A- 0 345 048
- WO-A-93/09414
- SENSORS AND ACTUATORS A, Bd.A21-A23, 1990, LAUSANNE, CH; Seiten 508-512; TAKAYAMA ET AL.: 'PYROELECTRIC INFRARED ARRAY SENSORS MADE OF C-AXIS-ORIENTED LA-MODIFIED PBTIO3 THIN FILMS'
- JOURNAL OF APPLIED PHYSICS, Bd.61, Nr.1, 1. Januar 1987, NEW YORK, US; Seiten 411-415; TAKAYAMA ET AL.: 'PREPARATION AND CHARACTERISTICS OF PYROELECTRIC INFRARED SENSORS MADE OF C-AXIS ORIENTED LA-MODIFIED PBTIO3 THIN FILMS'

## Beschreibung

Ein Pyrodetektor besteht aus einer aktiven Sensorschicht aus einem pyroelektrischen Material, welche beidseitig mit einer Elektrode beschichtet ist. Als pyroelektrische Materialien werden beispielsweise Bleizirkonattitanate (PZT) vorzugsweise Bleititanat oder organische Pyroelektrika wie Polyvinylidenfluorid (PVDF) verwendet. Eine dauerhafte Polarisierung des Pyroelektrikums kann in einem starken elektrischen Feld erfolgen oder stellt sich bei orientiertem Aufwachsen des Pyroelektrikums von selbst ein.

Durch Absorption von infraroter Strahlung in einem Pyrodetektor kommt es zu einer Temperaturerhöhung, die eine Änderung der Polarisation des pyroelektrischen Materials bewirkt, wobei sich eine an den beiden Elektroden ablesbare Spannung aufbaut. Um bei einer gegebenen einfallenden Strahlung ein maximales Meßsignal zu erhalten, müssen einerseits die pyroelektrischen Eigenschaften des Materials optimiert werden. Da andererseits auch das Ausmaß der durch die Absorption der IR-Strahlung bewirkten Temperaturerhöhung die Größe des Meßsignals beeinflußt, sind Pyrodetektoren zusätzlich auf eine möglichst geringe Wärmekapazität hin optimiert. Dies erfolgt üblicherweise durch Reduzierung der Schichtdicken des Detektorelements und durch Rückätzen des Substrats, auf dem das Detektorelement üblicherweise aufgebaut wird. So sind beispielsweise Detektorelemente mit "freischwebenden" Polysiliziummembranen im Abstand von etwa 1 µm zur Substratoberfläche bekannt. Auch das Ätzen von dünnen Siliziummembranen und freistehenden Zungen aus Silizium sowie das Ätzen von Wannen im Siliziumsubstrat unter der pyroelektrischen Schicht ist bekannt. Um das Substrat selektiv gegen die pyroelektrische Schicht bzw. gegen die erste Elektrodenschicht zu ätzen, wird vor dem Aufbau des Detektorelements eine zusätzliche Ätzstopschicht auf dem Substrat aufgebaut, die beispielsweise eine amorphe Schicht aus Siliziumdioxid oder Siliziumnitrid ist.

Um Pyrodetektoren mit guten elektrischen Eigenschaften zu erhalten, die große Ströme als Meßsignale liefern, sollte die Polarisationsrichtung des Pyroelektrikums senkrecht zu den Elektrodenflächen und damit senkrecht auf der Substratoberfläche stehen. Da die Polarisation der Perowskite aus der PZT-Familie nur bestimmte Richtungen im Kristall einnehmen kann, muß die pyroelektrische Schicht zumindest orientiert und noch besser epitaktisch auf das Substrat aufgebracht werden. Dafür sind bestimmte einkristalline Substratmaterialien erforderlich. Aus R. Takayama, Y. Tomita, J. Asayama, K. Nomura und H. Ogawa, "Pyroelekctric Infrared Array Sensors Made of c-Axis-oriented La-modified PbTiO₃ Thin Films", Sensors and Actuators, A21 - A23, 508 - 512 (1990), ist ein pyroelektrisches IR-Detektor-Array auf der Basis von c-Achsen orientierten Lanthan modifizierten Bleititanatdünnschichten (PLT) bekannt. Die PLT-Dünnschicht wird dabei auf einem Magnesiumoxideinkristall als Substrat orientiert aufgewachsen. In einem späteren Verfahrensschritt wird die PLT-Schicht durch Rückätzen des Magnesiumoxidsubstrats freigelegt und von unten mit einer Elektrode beschichtet.

Nachteilig an diesem bekannten Pyrodetektorarray ist die aufwendige Verschaltung der teilweise "unter dem Substrat" verlaufenden Elektroden, die mit einer externen Auslese- und Auswerteschaltung verbunden werden müssen.

Aus der US-A-3 816 750 ist ein durch Heißpressen hergestellter keramischere Pyrodetektor auf der Basis von Lathan-dotiertem Bleicirkonattitanat bekannt.

Aus Material Research Symposium Proc., Vol. 200 (1990), Seite 13 bis 18, sind pyroelektrische Schichten über geglühtem Quarz bekannt, welche durch Sol-Gel-Verfahren hergestellt werden.

Aus Material Research Sympositum Proc., Vol. 243 (1992), Seiten 107 bis 112 ist die Herstellung pyroelektrischer Schichten durch Sol-Gel-Verfahren bekannt. Es wird ein Siliziumsubstrat mit Metallelektroden verwendet.

Aus Ferroelectrics, Vol. 128 (1992), Seiten 37 bis 42, ist die Herstellung pyroelektrischer Schichten über einem mit Platin-elektroden versehenen Siliziumsubstrat bekannt.

Aus Material Research Bulletin, Vol. 25 (1990), Seiten 1495 bis 1501, sind pyroelektrische PZT-Schichten auf Silizium oder Saphir bekannt.

Der vorliegenden Erfindung liegt das Problem zugrunde, ein Dünnschichtpyrodetektorelement anzugeben, das aus einer orientierten pyroelektrischen Dünnschicht aufgebaut ist, eine niedrige Wärmekapazität besitzt und das eine einfachere und integrierte elektrische Verschaltung für Aufbau und Betrieb des Detektorarrays ermöglicht.

Diese Aufgabe wird erfindungsgemäß durch ein Dünnschichtpyrodetektorelement mit den Merkmalen von Anspruch 1 oder 2 gelöst. Weitere Ausgestaltungen der Erfindung sowie ein Verfahren zur Herstellung des Pyrodetektorelements sind den übrigen Ansprüchen zu entnehmen.

Die Erfindung gibt erstmals ein Pyrodetektorelement an, das orientiert auf einem Siliziumsubstrat aufgewachsen ist und daher die zusätzliche Integration von Auslese- und Auswerteschaltungen für das Detektorelement bzw. für eine Anordnung von mehreren, zu einem Pyrodetektorarray zusammenfaßten Pyrodetektorelementen erlaubt. Durch die Auswahl geeigneter Bufferschichten und/oder neuer Materialkombinationen für Elektrode/pyroelektrische Schicht gelingt:
a) die Erzeugung von dünnen Membranen mit günstiger Kristallorientierung zur Abscheidung orientierter oder epitaktischer pyroelektrischer Schichten, zum Beispiel Bleititanat,
b) die Einführung neuer Elektrodenmaterialien, die aufgrund enger struktureller Verwandtschaft die Abscheidung orientierter oder epitaktischer pyroelektrischer Schichten ermöglicht.

Aus dem bereits zitierten Artikel von Takayama et al war es bislang nur bekannt, orientierte pyroelektrische Schichten direkt über einkristallinem Magnesiumoxid zu erzeugen. Die Materialkombination des erfindungsgemäßen Pyrodetektorelements ist derart ausgelegt, daß über dem einkristallinen Siliziumsubstrat sowohl die Buffer- als auch die Elektroden- und die pyroelektrische Schicht orientiert oder gar epitaktisch aufwachsen können. Die Bufferschicht ermöglicht außerdem ein einfaches Rückätzen des Substrates, da sie gleichzeitig als Ätzstopschicht beim Ätzen des Siliziumsubstrats dienen kann. Im fertigen Pyrodetektorelement bildet die Bufferschicht eine dünne freitragende Membrane, die wiederum das Detektorelement trägt.

Die Membrane bzw. die Bufferschicht kann in beliebiger Dicke erzeugt werden, weist jedoch üblicherweise eine solche Dicke auf, daß sie zusammen mit dem aktiven Teil des Pyrodetektorelements ausreichend mechanische Stabilität besitzt, um den durch Rückätzen des Substrats nun "substratfreien" Raum unter dem aktiven Detektorbereich zu überbrücken, ohne einen Bruch oder eine sonstige Beschädigung während des Betriebs des Pyrodetektorelements befürchten zu müssen.

Eine Ausführungsform der Erfindung betrifft die Verwendung einer Spinell-Schicht (MgAl₂O₄) als Zwischenschicht, über der epitaktisch oder zumindest orientiert eine Magnesiumoxidschicht aufwächst. Auf der Magnesiumoxidoberfläche wird dann die erste Elektrodenschicht aufgebracht. Gut geeignet für die erste Elektrodenschicht ist Platin, das orientiert bis epitaktisch über dem Magnesiumoxid aufwächst. Für die darauf aufzubringende pyroelektrische Schicht wird ein Perowskit aus der PZT-Familie ausgewählt, beispielsweise ein Bleititanat PbTiO₃, das über Magnesiumoxid bzw. über der dazwischenliegenden Platinelektrodenschicht ein orientiertes Wachstum zeigt.

Das Material für die zweite bzw. obere Elektrodenschicht über der pyroelektrischen Schicht ist unkritisch, da es außer einer ausreichenden Leitfähigkeit nur noch mit dem pyroelektrischen Material, insbesondere mit dem darin enthaltenen Blei Verträglichkeit aufweisen muß und eintreffende Wärmestrahlung möglichst gut absorbieren sollte. Möglich ist es beispielsweise, eine Nickel/Chrom-Legierung für die zweiten Elektrodenschicht zu verwenden.

In einer weiteren Ausführungsform der Erfindung wird als Bufferschicht ein vollstabilisiertes Yttrium-stabilisiertes Zirkonoxid ZrO₂ (YSZ) verwendet, welches bislang nur als Bufferschicht für Hochtemperatursupraleiter bekannt war. Auch hier kann Platin als erste Elektrodenschicht verwendet werden, da es auf YSZ orientiert aufwächst. Die pyroelektrische Schicht wird dann wieder von einem Bleititanat, beispielsweise von (Pb, Ca) (Ti, Mn) O₃ gebildet.

In einer weiteren Ausgestaltung der Erfindung wird die erste Elektrodenschicht über der YSZ-Bufferschicht aus einem elektronisch leitenden ABO₃-Material hergestellt, wofür sich insbesondere Manganate und Kobaltate eignen. Über einer ersten Elektrodenschicht aus beispielsweise (La, Ca) MnO₃ wird dann eine Bleititanatschicht, beispielsweise (Pb, Ca) (Ti, Mn) O₃ als pyroelektrische Schicht aufgebracht.

In einer besonders vorteilhaften Variante der eben beschriebenen Ausführungsform wird die Materialkombination Elektrode/Pyroelektrikum so gewählt, daß beide Schichten die gleichen Kationen enthalten und sich nur durch das Kationenverhaltnis auf dem A- und B-Platz unterscheiden. Eine erfindungsgemäße Materialkombination besteht daher in einer ersten Elektrodenschicht aus (La, Pb) Mn, Ti) O₃ und (Pb, La) (Ti, Mn) O₃ als pyroelektrische Schicht. In dieser Ausführung ergibt sich eine besonders einfache Herstellung, wobei Elektrode und Pyroelektrikum zwei unterschiedliche Schichten darstellen können, oder zusammen eine einzige Schicht mit einem entsprechenden Gradienten des Kationenverhältnisses bilden. Dabei kann eine besonders gute Gitteranpassung und in der Folge eine besonders hoch orientierte pyroelektrische Schicht erzeugt werden.

Für die Erzeugung der unterschiedlichen Schichten der erfindungsgemäßen Pyrodetektorelemente sind bekannte Dünnschichtverfahren geeignet, beispielsweise Sputtern, MOCVD, Sol-Geld Spin-On, Pulsed Laser Deposition oder andere Gasphasen- und Plasma-abscheidsverfahren. Der Grad der Orientierung der aufwachsenden Schichten kann durch ein entsprechend langsames Aufwachsen und geeignet gewählte Aufwachstemperaturen gesteigert werden.

Im folgenden wird die Erfindung anhand von Ausführungsbeispielen und der dazugehörigen vier Figuren näher erläutert. Dabei zeigen
- die Figuren 1 bis 3: einen schematischen Querschnitt durch ein erfindungsgemäßes Pyrodetektorelement während verschiedener Verfahrensstufen bei der Herstellung und
- Figur 4: einen schematischen Querschnitt durch ein fertiges Pyrodetektorelement nach einer weiteren Ausführungsform der Erfindung.

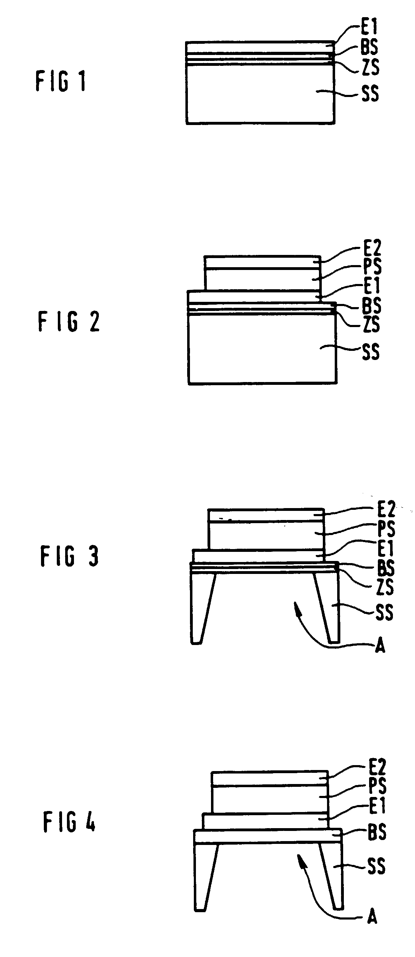

Figur 1 : Auf einem monokristallinen Siliziumsubstrat SS mit (100) orientierter und polierter Oberfläche wird nach bekannten Dünnschichtverfahren, beispielsweise durch Aufsputtern, Aufdampfen CVD, MOCVD usw. eine Reihenfolge von Schichten jeweils ganzflächig aufgebracht. Direkt über dem Siliziumsubstrat SS wird eine Zwischenschicht ZS aus Spinell MgAl₂O₄ aufgebracht, darüber eine Bufferschicht BS aus Magnesiumoxid MgO und darüber die erste Elektrodenschicht E1. Die unterschiedlichen Schichten werden gegebenenfalls mit unterschiedlichen Abscheidebedingungen bezüglich Temperatur, Druck oder Verfahren aufgebracht, wobei die Abscheidetemperatur und die erzielte Aufwachsgeschwindigkeit das Aufwachsen von zumindest orientierten, besser epitaktischen Schichten erlaubt.

Die Schichtdicken von Zwischenschicht ZS, Bufferschicht BS und erster Elektrodenschicht E1 werden möglichst dünn gewählt, um eine möglichst gute Orientierung beim Aufwachsen trotz der Gitterfehlanpassung zu erzielen. Zwischenschicht ZS und Bufferschicht BS sollten zusammen jedoch so dick und mechanisch stabil sein, daß sie ihre Membranfunktion erfüllen und das darüber aufgebaute Pyrodetektorelement bzw. Pyrodetektorarray zumindest über dessen Fläche frei tragen können. Dafür ist eine Schichtdicke von zusammen ca. 1 µm ausreichend. Die minimale Dicke der ersten Elektrodenschicht E1 ist durch die Stromleitfähigkeit des Materials der ersten Elektrodenschicht begrenzt. Eine metallische und beispielsweise aus Platin bestehende erste Elektrodenschicht kann mit ca. 100 nm entsprechend dünner ausgeführt werden als beispielsweise eine Elektrodenschicht aus einer elektrisch leitenden ABO₃-Verbindung.

Über der ersten Elektrodenschicht E1 wird nun eine pyroelektrische Schicht PS aus einem Bleititanat in einer Dicke von ca. 1 µm orientiert aufgewachsen.

Die zweite Elektrodenschicht E2 wird ganzflächig über der pyroelektrischen Schicht PS aufgebracht, beispielsweise durch Aufdampfen eines Metalles und anschließend mit Hilfe einer Photostrukturierungstechnik strukturiert, also durch Aufbringen eines Photolackes, bildmäßiges Belichten einer gewünschten Struktur, Entwickeln des Photolackes und Abtragen der Elektrodenschicht E2 in den nicht von Photolack bedeckten Bereichen, beispielsweise durch Ätzen. In einem weiteren Photostrukturierungsschritt wird die einheitliche pyroelektrische Schicht PS in eine Vielzahl von den Einzeldetektoren entsprechenden Schichtbereichen aufgeteilt, beispielsweise durch Ätzen. Die räumliche Trennung von Einzeldetektoren in einem Pyrodetektorarray ist notwendig, um zwischen zwei benachbarten Einzeldetektoren eine Wärmebrücke und damit das Übersprechen beim Detektieren eines IR-Signals zu minimieren.

Nach der Strukturierung der pyroelektrischen Schicht kann die erste Elektrodenschicht E1 wiederum mit Photostrukturierungsverfahren strukturiert werden. Figur 2 zeigt diese Anordnung. Die untere Elektrode kann aber auch ganzflächig belassen werden.

Zum Anschluß der zweiten Elektrodenschicht E2 an den Ausleseschaltkreis werden nach dem Aufbringen einer geigneten elektrischen Isolation Leiterbahnen aufgebracht und strukturiert. Diese zusätzlichen Elektrodenstrukturen sind in Figur 2 nicht gezeigt.

Zur Verbesserung der IR-Absorption des Pyrodetektorelements wird abschließend eine Absorberschicht aufgebracht, die beispielsweise aus Goldschwarz besteht.

Zur Verringerung der Wärmekapazität und der Wärmeleitung ins Substrat des Pyrodetektorelementes wird nun das Substrat SS im Bereich des oder der Pyrodetektoren weggeätzt. Dabei ist es möglich, mittels einer Photolacktechnik unter jedem Einzeldetektor eine Ausnehmung im Substrat SS zu erzeugen, oder in größeren Ausnehmungen gleichzeitig eine Reihe von Einzeldetektoren freizulegen, bzw. das Substrat unter dieser Reihe von Einzeldetektoren zu entfernen.

Bei der alkalischen Ätzung des Siliziumsubstrats SS dient die Zwischenschicht ZS als Ätzstopschicht. Der auf der Oberseite des Siliziumsubstrats aufgebrachte Schichtaufbau der Pyrodetektorelemente wird bei diesem Ätzschritt durch eine geeignete Abdeckschicht geschützt.

Figur 3 zeigt die Anordnung nach diesem Verfahrensschritt. In der Ausnehmung A des Siliziumsubstrats SS ist die Zwischenschicht ZS im Bereich des Pyrodetektorelements (E1, PS, E2) freigelegt. Die Ausnehmung kann exakt den Ausmaßen des Pyrodetektorelements entsprechen, oder etwas größer oder kleiner gestaltet sein. Eine geeignete Grundfläche für ein einzelnes Pyrodetektorelement beträgt beispielsweise 50 x 50 µm², wobei ein Pyrodetektorarray zumindest zwei mal zwei, also vier Einzeldetektoren umfaßt. Eine bessere Ortsauflösung eines detektierten IR-Signals wird mit größeren Arrays erhalten, die aus mehr Einzeldetektoren bestehen.

Die Schaltungen, die zum Betrieb eines Pyrodetektorelements bzw. eines Pyrodetektorarrays erforderlich sind, sind vorzugsweise auf dem Siliziumsubstrat SS integriert. Sie bestehen im wesentlichen aus Ausleseschaltung zum Ansprechen der Einzeldetektoren und Verstärkerschaltungen zum Verstärken der schwachen Meßsignale. Die Erzeugung der Schaltungen erfolgt normalerweise vor dem Herstellen des Pyrodetektorelements bzw. der Pyrodetektorelemente.

Figur 4 zeigt eine weitere Ausführungsform der Erfindung, bei der das aus erster Elektrodenschicht E1, pyroelektrischer Schicht PS und zweiter Elektrodenschicht E2 bestehende Pyrodetektorelement auf einer Bufferschicht BS aus voll mit Yttrium stabilisiertem Zirkonoxid (YSZ) aufgebaut ist. Auch hier fungiert die YSZ-Bufferschicht BS als Ätzstopschicht zur Erzeugung der Ausnehmung A im Siliziumsubstrat SS.

Ein voll integriertes und zusammen mit den erforderlichen Schaltungen auf einem einzigen (Silizium) Substrat untergebrachtes Pyrodetektorelement bzw. eine Anordnung von mehreren solchen Pyrodetektorelementen hat den Vorteil einer kompakten Bauweise, ist daher handlicher als bekannte Pyrodetektoren, bei denen Detektoren und die dazugehörige Elektronik auf getrennten Substraten untergebracht ist, ist leichter und kostengünstiger herstellbar und besitzt funktionale Vorteile.

Die kompakte Bauweise erlaubt es, mit geringerem Primärsignal aus dem Pyrodetektorelement zu arbeiten, weil das Signal in unmittelbarer Nähe zum Detektorelement durch geeignete Schaltungen verstärkt werden kann. Der Aufbau des Pyrodetektorelementes als dünne Schicht ermöglicht außerdem ein schnelleres Ansprechen des Pyrodetektors gegenüber einfallender IR-Strahlung.

## Patentansprüche

1. Pyrodetektorelement in Dünnschichtbauweise mit
a) einem monokristallinen Siliziumsubstrat (SS)
b) einer über dem Siliziumsubstrat aufgebrachten, epitaktischen Bufferschicht (BS) aus Yttrium-stabilisiertem Zirkonoxid YSZ
oder
einer über dem Siliziumsubstrat aufgebrachten epitaktischen Zwischenschicht (ZS) aus Spinell und einer darüber aufgebrachten zumindest orientierten Bufferschicht (BS) aus Magnesiumoxid
c) einer orientierten oder epitaktischen ersten Elektrodenschicht (E1)
d) einer c-Achsen-orientierten pyroelektrischen Schicht (PS) aus der Familie der Perowskite und
e) einer zweiten Elektrodenschicht (E2).

2. Pyrodetektorelement nach Anspruch 1,
bei dem die erste Elektrodenschicht (E1) aus Platin besteht.

3. Pyrodetektorelement nach Anspruch 1,
bei dem die erste Elektrodenschicht (E1) aus einem elektrisch leitenden Oxid aus der Klasse der Perowskite mit der allgemeinen Summenformel (LaCa) (MnCo) O₃ oder (LaPbCa) (MnCoTi) O₃ besteht und bei dem die pyroelektrische Schicht (PS) aus den gleichen Komponenten wie die erste Elektrodenschicht (E1) besteht, jedoch ein anderes Kationenverhaltnis aufweist.

4. Pyrodetektorelement nach Anspruch 3,
bei dem die erste Elektrodenschicht (E1) und die pyroelektrische Schicht (PS) zumindest einen gemeinsamen Bereich mit einem sich kontinuierlich in Richtung Schichtdicke ändernden Kationenverhaltnis aufweisen.

5. Pyrodetektorelement nach Anspruch 1 oder 2,
bei dem die pyroelektrische Schicht ein Perowskitmaterial aus der Familie der Bleizirkonattitanate umfaßt.

6. Pyrodetektorelement nach einem der vorangehenden Ansprüche,
bei dem das Siliziumsubstrat (SS) im Bereich der aktiven Sensorfläche des Pyrodetektorelements eine die Zwischenschicht (ZS) oder die Bufferschicht (BS) freilegende Ausnehmung (A) besitzt.

7. Pyrodetektorelement nach einem der vorangehenden Ansprüche,
welches Teil einer Anordnung von mehreren Pyrodetektorelementen auf einem gemeinsamen Siliziumsubstrat (SS) ist.

8. Verfahren zur Herstellung eines Pyrodetektorelements in Dünnschichtbauweise mit den Schritten
- Vorsehen eines monokristallinen Siliziumsubstrats (SS)
- orientiertes Aufwachsen einer Zwischenschicht (ZS) aus Spinell
- orientiertes Abscheiden einer Bufferschicht (BS) aus Magnesiumoxid
- orientiertes Abscheiden einer ersten Elektrodenschicht (E1)
- orientiertes Aufwachsen einer pyroelektrischen Schicht (PS) aus einem pyroelektrischen Material aus der Familie der Perowskite
- Erzeugen einer metallischen zweiten Elektrodenschicht (E2)
- Rückätzen des Siliziumsubstrats (SS) unter dem Pyrodetektorelement im Bereich dessen aktiver Sensorflache, wobei die Bufferschicht (BS) als Ätzstopschicht dient und
- Herstellung von elektrischen Anschlüssen zur elektrischen Verschaltung der beiden Elektrodenschichten.

9. Verfahren zur Herstellung eines Pyrodetektorelements in Dünnschichtbauweise mit den Schritten
- Vorsehen eines monokristallinen Siliziumsubstrats (SS)
- orientiertes Abscheiden einer Bufferschicht (BS) aus Yttrium-stabilisiertem Zirkonoxid (YSZ)
- orientiertes Abscheiden einer ersten Elektrodenschicht (E1)
- orientiertes Aufwachsen einer pyroelektrischen Schicht (PS) aus einem pyroelektrischen Material aus der Familie der Perowskite
- Erzeugen einer metallischen zweiten Elektrodenschicht (E2)
- Rückätzen des Siliziumsubstrats (SS) unter dem Pyrodetektorelement im Bereich dessen aktiver Sensorfläche, wobei die Bufferschicht (BS) als Ätzstopschicht dient und
- Herstellung von elektrischen Anschlüssen zur elektrischen Verschaltung der beiden Elektrodenschichten.

10. Verfahren nach Anspruch 8 oder 9,
bei dem nach ganzflächigem Aufbringen der einzelnen Schichten (E1, PS und E2) zumindest eine Photostrukturierungstechnik durchgeführt wird, um eine Anordnung mehrerer voneinander getrennter und daher thermisch gegeneinander isolierter Pyrodetektorelemente auf dem Siliziumsubstrat (SS) zu erzeugen.

11. Verfahren nach Anspruch 10,
bei dem im Siliziumsubstrat (SS) mikroelektronische Auslese- und Verstärkerschaltungen für die Anordnung der Pyrodetektorelemente auf dem Siliziumsubstrat vorgesehen werden.

## Claims

1. Pyrodetector element of thin-film construction comprising
a) a monocrystalline silicon substrate (SS)
b) an epitaxial buffer layer (BL) which is applied above the silicon substrate and is made of yttrium-stabilized zirconium oxide YSZ
or
an epitaxial interlayer (IL) which is applied above the silicon substrate and is made of spinel and an at least oriented buffer layer (BL) applied there-above, which is made of magnesium oxide
c) an oriented or epitaxial first electrode layer (E1)
d) a c-axis-oriented pyroelectric layer (PL) from the family of the perovskites and
e) a second electrode layer (E2).

2. Pyrodetector element according to Claim 1,
wherein the first electrode layer (E1) is made of platinum.

3. Pyrodetector element according to Claim 1,
wherein the first electrode layer (E1) is made of an electrically conductive oxide from the class of the perovskites having the general empirical formula (LaCa) (Mnco) O₃ or (LaPbCa) (MnCoTi) O₃ and wherein the pyroelectric layer (PL) is made of the same components as the first electrode layer (E1), but has a different cation ratio.

4. Pyrodetector element according to Claim 3,
wherein the first electrode layer (E1) and the pyroelectric layer (PL) have at least one common region having a cation ratio which changes continuously in the layer thickness direction.

5. Pyrodetector element according to Claim 1 or 2,
wherein the pyroelectric layer comprises a perovskite material from the family of the lead zirconate titanates.

6. Pyrodetector element according to any one of the preceding claims,
wherein the silicon substrate (SS) has, in the region of the active sensor face of the pyrodetector element, a recess (R) which exposes the interlayer (IL) or the buffer layer (BL).

7. Pyrodetector element according to any one of the preceding claims,
which forms part of an arrangement of a plurality of pyrodetector elements on a common silicon substrate (SS).

8. Method for fabricating a pyrodetector element of thin-film construction, which comprises the steps of
- providing a monocrystalline silicon substrate (SS)
- oriented growth of an interlayer (IL) made of spinel
- oriented deposition of a buffer layer (BL) made of magnesium oxide
- oriented deposition of a first electrode layer (E1)
- oriented growth of a pyroelectric layer (PL) made of a pyroelectric material from the family of the perovskites
- generating a metallic second electrode layer (E2)
- etch-back of the silicon substrate (SS) underneath the pyrodetector element in the region of the active sensor face of the latter, the buffer layer (BL) serving as an etch stop layer and
- establishing electrical connections for the electrical interconnection of the two electrode layers.

9. Method for fabricating a pyrodetector element of thin-film construction, which comprises the steps of
- providing a monocrystalline silicon substrate (SS)
- oriented deposition of a buffer layer (BL) made of yttrium-stabilized zirconium oxide (YSZ)
- oriented deposition of a first electrode layer (E1)
- oriented growth of a pyroelectric layer (PL) made of a pyroelectric material from the family of the perovskites
- generating a metallic second electrode layer (E2)
- etch-back of the silicon substrate (SS) underneath the pyrodetector element in the region of the active sensor face of the latter, the buffer layer (BL) serving as an etch stop layer and
- establishing electrical connections for the electrical interconnection of the two electrode layers.

10. Method according to Claim 8 or 9,
wherein, after allover application of the individual layers (E1, PL and E2), at least one photopatterning technique is carried out in order to produce an arrangement of a plurality of mutually separated and consequently mutually thermally insulated pyrodetector elements on the silicon substrate (SS).

11. Process according to Claim 10,
wherein there are provided, in the silicon substrate (SS), microelectronic read-out and amplifier circuits for the arrangement of the pyrodetector elements on the silicon substrate.

## Revendications

1. Elément pyrodétecteur selon une forme de construction en couche mince avec
a) un substrat de silicium (SS) monocristallin
b) une couche tampon épitaxée (BS) appliquée sur le substrat de silicium, en oxyde de zircone stabilisé par de l'yttrium YSZ
ou
une couche intermédiaire épitaxée (ZS) en spinelle appliquée sur le substrat de silicium et une couche tampon (BS) d'oxyde de magnésium appliquée au-dessus d'elle et au moins orientée
c) une première couche d'électrode (E1) orientée ou épitaxée
d) une couche pyroélectrique (PS) de la famille des perovskites orientée selon l'axe c et
e) une deuxième couche d'électrode (E2).

2. Elément pyrodétecteur selon la revendication 1,
pour lequel la première couche d'électrode (E1) se compose de platine.

3. Elément pyrodétecteur selon la revendication 1,
pour lequel la première couche d'électrode (E1) se compose d'un oxyde conducteur de la classe des perovskites avec la formule générale (LaCa) (MnCo) O₃ ou (LaPbCa) (MnCoTi) O₃ et pour lequel la couche pyroélectrique (PS) se compose des mêmes composants que la première couche d'électrode (E1), mais avec une autre proportion des cations.

4. Elément pyrodétecteur selon la revendication 3,
pour lequel la première couche d'électrode (E1) et la couche pyroélectrique (PS) présentent au moins un domaine commun avec une proportion des cations se modifiant continûment dans la direction de l'épaisseur de la couche.

5. Elément pyrodétecteur selon la revendication 1 ou 2,
pour lequel la couche pyroélectrique comprend un matériau perovskite de la famille des titanates-zirconates de plomb.

6. Elément pyrodétecteur selon l'une des revendications précédentes,
pour lequel le substrat de silicium (SS) possède dans le domaine de la surface détectrice active du pyrodétecteur un évidement (A) mettant à nu la couche intermédiaire (ZS) ou la couche tampon (BS).

7. Elément pyrodétecteur selon l'une des revendications précédentes,
lequel fait partie d'un arrangement de plusieurs éléments pyrodétecteurs sur un substrat de silicium (SS) commun.

8. Procédé pour la fabrication d'un élément pyrodétecteur selon une forme de construction en couche mince avec les étapes consistant à
- prévoir un substrat de silicium (SS) monocristallin
- faire croître de manière orientée une couche intermédiaire (ZS) en spinelle
- déposer de manière orientée une couche tampon (BS) d'oxyde de magnésium
- déposer de manière orientée une première couche d'électrode (E1)
- faire croître de manière orientée une couche pyroélectrique (PS) d'un matériau pyroélectrique de la famille des perovskites
- fabriquer une deuxième couche d'électrode (E2) métallique
- graver en retrait du substrat de silicium (SS) sous le pyrodétecteur dans le domaine pour lequel la surface détectrice dudit détecteur est active, la couche tampon (BS) servant de couche d'arrêt de gravure et
- fabriquer les connexions électriques pour la liaison électrique des deux couches d'électrodes.

9. Procédé pour la fabrication d'un élément pyrodétecteur selon une forme de construction en couche mince avec les étapes consistant à
- prévoir un substrat de silicium (SS) monocristallin
- déposer de manière orientée une couche tampon (BS) d'oxyde de zircone stabilisé par de l'yttrium (YSZ)
- déposer de manière orientée une première couche d'électrode (E1)
- faire croître de manière orientée une couche pyroélectrique (PS) d'un matériau pyroélectrique de la famille des perovskites
- fabriquer une deuxième couche d'électrode (E2) métallique
- graver en retrait du substrat de silicium (SS) sous le pyrodétecteur dans le domaine pour lequel la surface détectrice dudit détecteur est active, la couche tampon (BS) servant de couche d'arrêt de gravure et
- fabriquer les connexions électriques pour la liaison électrique des deux couches d'électrodes.

10. Procédé selon la revendication 8 ou 9,
pour lequel après application sur toute la surface des différentes couches (E1, PS et E2), au moins une technique de structuration photo est exécutée, afin de fabriquer un arrangement de plusieurs éléments pyrodétectéurs séparés les uns des autres et donc isolés thermiquement les uns contre les autres sur le substrat de silicium (SS).

11. Procédé selon la revendication 10,
pour lequel des circuits de lecture et d'amplification sont prévus dans le substrat de silicium (SS) pour l'arrangement d'éléments pyrodétecteurs sur le substrat de silicium.
